# EUROPEAN PATENT APPLICATION

(11) **EP 2 525 399 A1**
(43) Date of publication of application: **21.11.2012**
(21) Application number: 10856616.7
(22) Date of filing: 16.11.2010
(51) Int. Cl.: H01L 23/31, H01L 23/48, H05K 3/34

(54) **CRYSTAL DEVICE WITHOUT PACKAGING AND MANUFACTURING METHOD THEREOF**

(30) Priority: 03.09.2010 CN 201010275494
(71) Applicant: ZTE Corporation, Shenzhen, Guangdong 518057 (CN)
(72) Inventor: LV, Fei, Shenzhen Guangdong 518057 (CN); GE, Hu, Shenzhen Guangdong 518057 (CN); SONG, Jie, Shenzhen Guangdong 518057 (CN)
(74) Representative: Kling, Simone
(86) International application number: PCT/CN2010/078788
(87) International publication number: WO 2012/027929

(57) **Abstract**

The disclosure discloses a crystal device without an external package, which comprises: a crystal body (21) and two pins (22), wherein the crystal body (21) is a cylindrical body port of a crystal with the external package (15) and redundant pins (12, 13) being removed, and is arranged on a Printed Circuit Board (PCB) horizontally. The two pins (22) are connected to a bottom end of the crystal body (21). Extension parts of the two pins (22) are inclined towards the PCB, and become horizontal when they reach the PCB and are welded to the PCB, and a spacing between the two pins (22) increases gradually. The disclosure also discloses a method for manufacturing a crystal device without a package. The device and method can reduce the cost and make the welding more convenient.

## Description

### TECHNICAL FIELD

The disclosure relates to the field of crystal manufacturing and assembly, particularly to a crystal device without an external package and a manufacturing method thereof.

### BACKGROUND

With the growing development of communication equipment and digital electronic products, competition is heating up, wherein the technical innovation of product and the characteristic of craft are the key for the success of competition. For the manufacturer, the main object of the technical innovation is to improve performance of the product, the characteristic improvement of the craft is to reduce the cost of the product; only when the cost is reduced can the sale price be reduced and the product be more competitive. However, while reducing the cost, the manufacturer must take into account the performance and quality of the product so as to try to meet the experience of the user.

At present, in the electronic equipment with a clock source, 32K crystal is a common electronic device. The parameter of the 32K crystal is as follows: frequency: 32.768KHz, load capacitance: 12.5pF, level of drive: 1.0µW Max, frequency tolerance: ±20ppm. Generally, the 32K crystal uses a plastic package as an external package and has smaller pins; in addition, the crystal shell inside the resin package shell probably partially exposes out, which cannot get an effect of 100% perfect package. In order to paste more conveniently when the package, two pins are needed to be added for balance the crystals; in this way, the complexity of pins and package would be increased, thus the manufacturing cost of the product is increased.

### SUMMARY

In view of the above, the main object of the disclosure is to provide a crystal device without an external package and a manufacturing method thereof, with a capability of reducing the manufacturing cost of the 32K crystal and making welding more convenient.

In order to achieve the object above, the technical scheme of the disclosure is realized as follows.

The disclosure provides a crystal device without an external package, which comprises: a crystal body and two pins, in which,
the crystal body is a cylindrical body port of a crystal with the external package and redundant pins being removed, and is arranged on a Printed Circuit Board (PCB) horizontally; and
the two pins are connected to a bottom end of the crystal body; extension parts of the two pins are inclined towards the PCB, and become horizontal when they reach the PCB and are welded to the PCB; and a spacing between the two pins increases gradually.

The welding may be performed by using a reflow soldering oven. The extension parts of the two pins may be inclined towards the PCB with an angle of 90 degrees to 100 degrees for each pin. The redundant pins may be pins added into the original external package for balance.

The disclosure further provides a method for manufacturing a crystal device without a package, which comprises:
removing the external package and redundant pins of a crystal to expose a cylindrical body part of the crystal and placing it on a PCB horizontally;
extending two pins from a bottom end of the crystal body horizontally, wherein the extension parts of the two pins are inclined towards the PCB, and become horizontal when they reach the PCB and are welded to the PCB, and a spacing between the two pins increases gradually.

The welding may be performed by using a reflow soldering oven, the welding process may comprise: during the welding by using the reflow soldering oven, an initial temperature of the PCB is 50□, the temperature of the reflow soldering oven rises straightly to 170±10□ within 50 seconds at a slope of 2.2 to 2.6, then maintains for 120±20 seconds, then rises straightly again to 250□ within 50 seconds at a slope of 1.3 to 2, then rises from 250□ to a highest temperature 260□ within 5 seconds, then begins to decrease from the highest temperature 260□ to 220□ at a slope of -2 to -1.3, and then the patch welding of the crystal is completed. The extension parts of the two pins may be inclined towards the PCB with an angle of 90 degrees to 100 degrees for each pin.

9. The method according to claim 5 or 6, wherein the redundant pins are pins added into the original external package for balance.

The crystal device without an external package and the manufacturing method thereof provided by the disclosure remove the external package and redundant pins of the 32K crystal with a plastic package to expose a cylindrical crystal body and place it on a PCB horizontally, wherein two pins are extended from a bottom end of the crystal body horizontally and are inclined towards the PCB, and then become horizontal when they reach the PCB and are welded to the PCB, wherein the spacing between the two pins increases gradually when inclining. In this way, on the premise of not influencing any performance of the crystal, the manufacturing cost is reduced; in addition, while the two pins are inclined towards the PCB, the distance there-between increases gradually, thus welding is more convenient.

### BRIEF DESCRIPTION OF THE DRAWINGS

Fig. 1 is a structure diagram of a 32K crystal with a plastic package;
Fig. 2 is a structure diagram of a crystal device without an external package according to the disclosure;
Fig. 3 is a preferred temperature control curve diagram for a reflow soldering oven according to the disclosure;
Fig. 4 is top views of two specifications of 32K crystals according to the disclosure; and
Fig. 5 is a flowchart of a method for manufacturing a crystal device without a package according to the disclosure.

### DETAILED DESCRIPTION

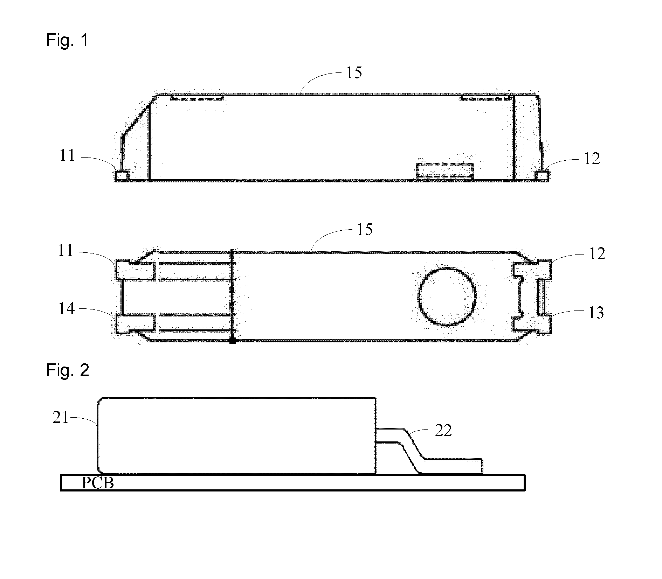

For a better understanding of the disclosure, firstly, illustrate the shape of the present 32K crystal with a plastic package. Fig. 1 is a structure diagram of a 32K crystal with a plastic package; as shown in Fig. 1, the above one is a side view of a 32K crystal; the lower one is a bottom view of the 32K crystal; the 32K crystal comprises: a pin 11, a pin 12, a pin 13, a pin 14 and a plastic package 15, wherein the pin 12 and the pin 13 are added for balance; the pin 11 and the pin 14 are the useful pins to which the 32K crystal are actually connected; a shell of the crystal is encapsulated with the plastic package 15.

The basic idea of the disclosure is: removing the external package and redundant pins of a 32K crystal with a plastic package to expose a crystal body and placing it on a PCB horizontally; extending two pins from a bottom end of the crystal body horizontally, wherein the extension parts of the two pins are inclined towards the PCB, and then become horizontal when they reach the PCB and are welded to the PCB, and a spacing between the two pins increases gradually when inclining.

Hereinafter, the technical scheme of the disclosure is further illustrated in conjunction with the drawings and specific embodiments.

Fig. 2 is a structure diagram of a crystal device without an external package according to the disclosure; as shown in Fig. 2, the crystal without the external package mainly refers to a 32K crystal, wherein the crystal comprises: a crystal body 21 and two pins 22, in which,

the crystal body 21 is a cylindrical body port of a crystal with the external package and redundant pins being removed, and is arranged on a PCB horizontally;

specifically, the redundant pins specifically refer to the pins added into the original external package for balance; for example, the pin 12 and the pin 13 in Fig. 1. The shell material of the crystal body is the material commonly adopted by a Surface Mounted Technology (SMT), for example: ceramic, resin, etc.

The two pins 22 are connected to a bottom end of the crystal body 21, extension parts of the two pins are inclined towards the PCB, and become horizontal when they reach the PCB and are welded to the PCB; and a spacing between the two pins 22 increases gradually when inclining.

Specifically, the two pins both are of metal material. Since the crystal body 21 is cylindrical, the two pins 22 connected to the bottom end of the cylinder cannot be welded to the PCB directly; therefore, the pins need to incline towards the PCB, wherein the inclining angle of the pin preferably is between 90 degrees and 100 degrees; while the two pins 22 are inclining, the spacing between the two pins increases gradually, so as to increase the spacing between the pins during welding, thus the welding or demounting is more convenient and the bad welding, caused when the pins are too near, can be avoided.

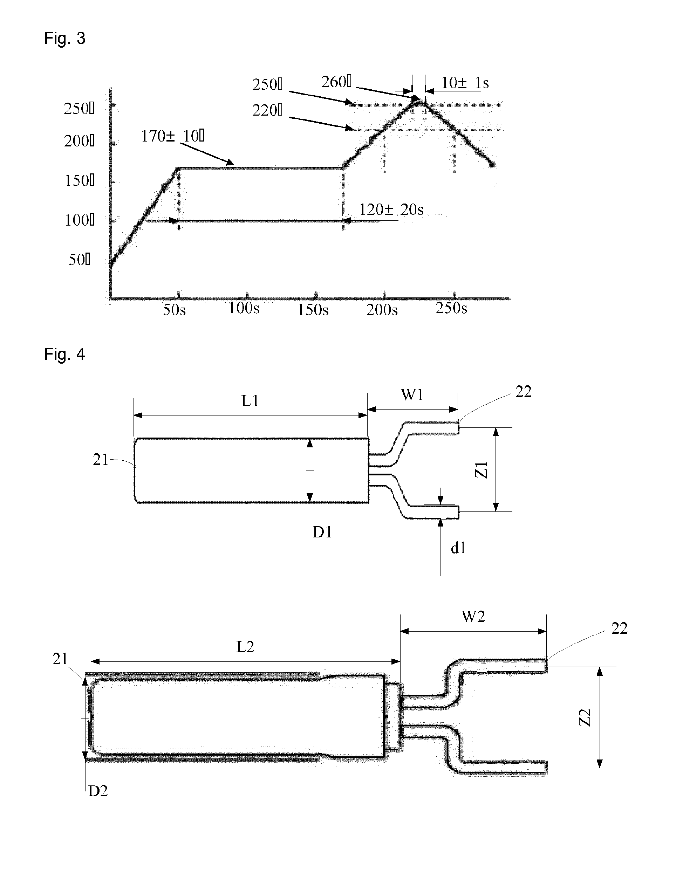

Further, the welding preferably can be performed by using a reflow soldering oven, wherein the welding process needs to operate according to a preset temperature control curve to achieve the best effect. Fig. 3 is a preferred temperature control curve for a reflow soldering oven according to the disclosure; as shown in Fig. 3, first, the initial temperature of the PCB is about 50□; the temperature of the reflow soldering oven rises straightly to 170±10□ within about 50 seconds at a slope of 2.2 to 2.6, then maintains for 120±20 seconds; at this moment, the total time consumed is about 150 to 190 seconds, then the temperature rises straightly again to 250□ within about 50 seconds at a slope of 1.3 to 2; then rises from 250□ to a highest temperature 260°C within about 5 seconds; after reaching the highest temperature 260°C, the temperature begins to decrease, wherein the process of rising from 250°C to 260°C and decreasing from 260°C to 250°C last 10±1 seconds; then the temperature begins to decrease straightly from 250°C to 220°C at a slope of -2 to -1.3; then the patch welding of the crystal is completed.

The following is the structure example of two specifications of 32K crystals adopted by the disclosure in the actual application. Fig. 4 is top views of two specifications of 32K crystals according to the disclosure; as shown in Fig. 4, the above one is a top view of the 32K crystal with smaller specification, the length L1 of the cylindrical crystal body 21 is 4.7 mm, the diameter D1 of the bottom circular surface of the crystal body is 1.2 mm, the distance W1 from the ends of the two pins 22 to the bottom end of the crystal body 21 from which the pins are extended is 1.8±0.2 mm, the spacing Z1 between the ends of the two pins 22 is 1.3±0.2 mm, the tangent planes of the two pins 22 are circular, with diameter d1 of 0.22±0.05 mm.

The lower one is a top view of the 32K crystal with bigger specification, the length L2 of the cylindrical crystal body 21 is 6.0±0.2 mm, the diameter D2 of the bottom circular surface is 2.0±0.1 mm, the distance W2 from the ends of the two pins 22 to the bottom end of the crystal body 21 from which the pins are extended is 2.7±0.3 mm, the spacing Z2 between the ends of the two pins 22 is 2.54±0.3 mm.

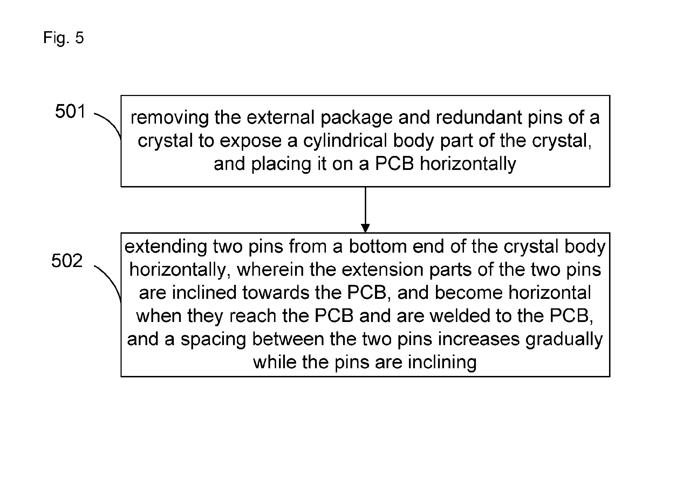

Fig. 5 is a flowchart of a method for manufacturing a crystal device without a package according to the disclosure. As shown in Fig. 5, the method for manufacturing the crystal device without the package comprises the following steps.

Step 501: removing the external package and redundant pins of a crystal to expose a cylindrical body part of the crystal, and placing it on a PCB horizontally.

Specifically, the redundant pins specifically refer to pins added into the original external package for balance; for example, the pin 12 and the pin 13 in Fig. 1. The shell material of the crystal body is the material commonly adopted by the SMT, for example: ceramic, resin, etc.

Step 502: extending two pins from a bottom end of the crystal body horizontally, wherein the extension parts of the two pins are inclined towards the PCB, and become horizontal when they reach the PCB and are welded to the PCB, and a spacing between the two pins increases gradually while the pins are inclining.

Specifically, the two pins both are of metal material. Since the crystal body is cylindrical, the two pins extended horizontally from the bottom end of the cylinder cannot be welded to the PCB directly; therefore, the pins need to incline towards the PCB, wherein the inclining angle of the pin preferably is between 90 degrees and 100 degrees; while the two pins are inclining, the spacing between the two pins increases gradually, so as to increase the spacing between the pins during welding, thus the welding or demounting is more convenient and the bad welding, caused when the pins are too near, can be avoided.

Further, the welding preferably can be performed by using a reflow soldering oven, wherein the welding process needs to operate according to a preset temperature control curve to achieve the best effect. The welding process specifically comprises: first, the initial temperature of the PCB is 50°C; the temperature of the reflow soldering oven rises straightly to 170±10°C within 50 seconds at a slope of 2.2 to 2.6, then maintains for 120±20 seconds, then rises straightly again to 250°C within 50 seconds at a slope of 1.3 to 2; after rising to 250°C, the temperate rises to a highest temperature 260°C within 5 seconds; after reaching the highest temperature 260°C, the temperature begins to decrease straightly to 220°C at a slope of -2 to -1.3; then the patch welding of the crystal is completed.

The above is only the preferred embodiment of the disclosure and not intended to limit the protection scope of the disclosure. Any modification, equivalent substitute and improvement made within the spirit and principle of the disclosure are deemed to be included within the protection scope of the disclosure.

## Claims

1. A crystal device without an external package, comprising: a crystal body and two pins, wherein
the crystal body is a cylindrical body port of a crystal with the external package and redundant pins being removed, and is arranged on a Printed Circuit Board (PCB) horizontally; and
the two pins are connected to a bottom end of the crystal body; extension parts of the two pins are inclined towards the PCB, and become horizontal when they reach the PCB and are welded to the PCB; and a spacing between the two pins increases gradually.

2. The device according to claim 1, wherein the welding is performed by using a reflow soldering oven.

3. The device according to claim 1 or 2, wherein the extension parts of the two pins are inclined towards the PCB with an angle of 90 degrees to 100 degrees for each pin.

4. The device according to claim 1 or 2, wherein the redundant pins are pins added into the original external package for balance.

5. A method for manufacturing a crystal device without a package, comprising:
removing the external package and redundant pins of a crystal to expose a cylindrical body part of the crystal and placing it on a PCB horizontally;
extending two pins from a bottom end of the crystal body horizontally, wherein the extension parts of the two pins are inclined towards the PCB, and become horizontal when they reach the PCB and are welded to the PCB, and a spacing between the two pins increases gradually.

6. The method according to claim 5, wherein the welding is performed by using a reflow soldering oven.

7. The method according to claim 6, wherein during the welding by using the reflow soldering oven, an initial temperature of the PCB is 50□, the temperature of the reflow soldering oven rises straightly to 170±10□ within 50 seconds at a slope of 2.2 to 2.6, then maintains for 120±20 seconds, then rises straightly again to 250□ within 50 seconds at a slope of 1.3 to 2, then rises from 250□ to a highest temperature 260□ within 5 seconds, then begins to decrease from the highest temperature 260□ to 220□ at a slope of -2 to -1.3, and then the patch welding of the crystal is completed.

8. The method according to claim 5 or 6, wherein the extension parts of the two pins are inclined towards the PCB with an angle of 90 degrees to 100 degrees for each pin.

9. The method according to claim 5 or 6, wherein the redundant pins are pins added into the original external package for balance.
